# EUROPÄISCHE PATENTANMELDUNG

(11) **EP 2 020 834 A2**
(43) Veröffentlichungstag der Anmeldung: **04.02.2009**
(21) Anmeldenummer: 08158424.5
(22) Anmeldetag: 17.06.2008
(51) Int. Cl.: H05K 3/12, H05K 3/46, B41M 1/00

(54) **Druckprodukt mit elektrisch funktionaler Schicht**

(30) Priorität: 04.07.2007 DE 102007031061
(71) Anmelder: manroland AG, 63075 Offenbach/Main (DE)
(72) Erfinder: Walther, Thomas, 63067 Offenbach (DE)

(57) **Zusammenfassung**

Die Erfindung betrifft ein Druckprodukt, bestehend aus einer transparenten Kunststofffolie mit einer Bildebene, die eine gedruckte Bildinformation aufweist. Weiterhin ist eine opake oder teilopake deckenden Ebene vorgesehen, die aus einem Deckweißauftrag aufgebaut wird. Zur kostengünstigen Herstellung von Funktionselementen ist ein Verfahren zur Herstellung des Druckproduktes vorgesehen, bei dem auf die deckende Ebene eine elektrisch funktionale Ebene aufgedruckt wird. Die elektrisch funktionale Ebene wird zumindest teilweise in einem drucktechnisch bekannten Verfahren erzeugt.

## Beschreibung

Die Erfindung betrifft ein Druckprodukt mit elektrisch funktionaler Schicht und ein dazu gehöriges Herstellungsverfahren.

Es ist bekannt mit Hilfe von mit elektrisch leitenden Bestandteilen gefüllten Druckfarben, wie zum Beispiel mit Silber gefüllten Druckfarben, oder mit leitfähigen Polymeren elektrische Funktionalitäten zu drucken. Zum Einsatz kommen zu diesem Zweck alle bekannten Druckverfahren, wie der Tintenstrahldruck, der Tiefdruck, der Siebdruck, der Offsetdruck oder der Hoch- und Flexodruck. Oftmals werden für den Druck der elektrischen Funktionalitäten auch Kombinationsdrucke der vorab erwähnten Druckverfahren eingesetzt.

Gedruckte elektrische Funktionalitäten bedeuten im einfachsten Fall gedruckte Leiterbahnen oder Tastenfelder für die Herstellung von Tastaturen und Spielen, Antennen für RFID (radio frequency identification device). Herstellbar sind auf die genannte Weise aber auch komplexere funktionale Elemente, wie Transistoren oder Speicheranwendungen.

Der Vorteil der gedruckten Elektronik liegt unter anderem in der möglichen Flexibilität der Druckprodukte. So können Folien mit Leiterbahnen sich zum Beispiel der Kontur eines Produktes anpassen oder auch zusammengerollt Platz sparend transportiert werden.

Vielfach wurde diskutiert die gedruckten funktionalen elektronischen Elemente zu überdrucken, um diese in dem Druckbild aufgehen zulassen. Die Eigenfarbe der gedruckten elektrischen Elemente, aber auch die oftmals, auch bei transparenten elektrisch leitfähigen Strukturen oder Elementen, mit der Zeit auftretenden Verfärbungen stören den visuellen und optischen Eindruck des Drucks. Druckfarben sind meist nicht deckend, sondern lasierend, also leicht durchscheinend, so dass sie den Untergrund durchscheinen lassen. Im Rasterdruck kommt noch zusätzlich erschwerend hinzu, dass die Zwischenräume zwischen den Rasterpunkten den Hintergrund deutlich erkennen lassen. Deswegen ist der direkte Druck eines farbigen Bildes auf eine leitfähige Struktur nur selten möglich.

Transparente Kunststofffolien werden klassisch zuerst mit einem Druckbild versehen auf das als letzte Schicht eine anschließende opake oder teilopake Deckweißschicht Inline während des Druckvorgangs oder Offline in einer separaten Beschichtungseinrichtung aufgetragen werden. Diese opake oder teilopake Deckweißschicht schließt die teilweise lasierenden Druckfarben ab und lässt diese brillanter erscheinen. Außerdem wird somit verhindert, dass durch die Folie hindurch auf den Untergrund oder auf den Verpackungsinhalt einer Verpackung hindurch gesehen werden kann. Typischerweise wird diese Druckreihenfolge Farbendruck und anschließenden Deckweißauftrag auf transparenten Folien zum Beispiel in der Kunststoffverpackungsherstellung angewandt. Der Vorteil liegt darin, dass die Druckschicht sich in der Verpackung befindet und durch die transparente Folie betrachtet werden kann. Die Kunststofffolie schützt das Druckbild gegen Verkratzen oder Beschädigung während des Transports und der Lagerung.

Es ist ferner bekannt, den opaken oder teilopaken Deckweißauftrag flächig oder auch nur partiell auf die zuvor aufgedruckten Bildelemente durchzuführen.

Aufgabe der Erfindung ist es, der auf einer transparenten Kunststofffolie aufgedruckte Bildinformationsebene durch eine weitere Funktionsebene zu ergänzen.

Gelöst wird die Aufgabe durch die Merkmale des Anspruchs 1.

Sinnvolle Weiterbildungen ergeben sich aus den jeweiligen Unteransprüchen.

Erfindungsgemäß ist vorgesehen, die auf einer transparenten Kunststofffolie aufgedruckte Bildinformationsebene von einer elektrischen Funktionsebene durch den Aufdruck einer Zwischenebene aus opaken oder teilopaken Deckweiß optisch zu isolieren.

Auf eine transparente Folie wird im Bogen- oder Rollenrotationsdruck zuerst eine Bildinformation aufgedruckt, wobei mindestens ein Teil des Bildes im Offset-, Tief-oder Flexodruck aufgedruckt wird, anschließend wird auf diese Bildschicht eine oder mehrere opake oder teilopake Deckweißschichten aufgedruckt oder in einem Beschichtungsverfahren aufgetragen.

Auf diese Deckweißschicht wird dann zu mindestens ein Teil der elektrisch funktionalen Schicht bzw. Schichten aufgedruckt. Hierbei kann aber auch eine vollständige elektrische Funktionalität vorgesehen sein. Der Aufdruck der elektrisch funktionalen Schicht bzw. Schichten erfolgt in einem der Druckverfahren Offsetdruck, Flexodruck oder Tiefdruck oder in einer Kombination der genannten Druckverfahren. Die funktionale elektrische Schicht kann dabei komplett drucktechnisch hergestellt sein, oder als so genannte Hybridanwendung gedruckte elektrische Funktionalität, zum Beispiel eine Leiterbahn, in Kombination mit diskreten elektrischen Bauelementen, wie zum Beispiel Chips, integrierte Schaltkreise (IC's) oder Kleinleuchtquellen (Leuchtdioden), wie LED's (light emitting devices), aufgebaut sein.

Der Druck der Bildinformation und der Deckweißauftrag auf der Kunststofffolie kann Inline, also während des Durchlaufens eines Druckprozesses durch eine Druckmaschine erfolgen. Weiterhin kann der Druck auch Offline erfolgen, indem der Deckweißauftrag in einer separaten Beschichtungsvorrichtung, zum Beispiel in einer Siebdruckvorrichtung, erfolgt.

Die Deckweißschicht kann dabei flächig oder partiell aufgebracht sein. Die Deckweißschicht kann Aussparungen aufweisen, die eine Durchkontaktierung erlauben oder eine Aussparung aufweisen, die das Durchscheinen einer elektrischen Beleuchtung oder Anzeige, zum Beispiel einer LED, erlauben.

Durch die erfindungsgemäß vorgeschlagene Lösung wird die Erzeugung eines brillanten Druckbildes ermöglicht, das nicht durch die gegebenenfalls optisch störend wirkenden Elemente einer elektrischen Funktionsschicht negativ beeinflusst wird.

Mit dem vorgeschlagenen Verfahren können vorteilhaft spezielle Druckprodukte erzeugt werden. Das vorgeschlagene Druckprodukt ist in seiner spezifischen Kombination von gedruckter Bildinformation und elektrisch funktionaler Information geeignet, wirkungsvolle Kunststoffverpackungen, Eingabetastaturen, oder auch Spiele herzustellen.

## Patentansprüche

1. Druckprodukt, bestehend aus einer transparenten Kunststofffolie, die gedruckte Information trägt, wobei eine Bildebene vorgesehen ist, die aus einer gedruckten Bildinformation besteht, und wobei weiterhin eine opake oder teilopak deckende Ebene vorgesehen ist, die aus einem Deckweißauftrag aufgebaut wird,
**gekennzeichnet dadurch,**
**dass** über der deckenden Ebene des Druckproduktes eine weitere Ebene mit gedruckten elektrisch funktionalen Elementen vorgesehen ist, wobei die elektrisch funktionalen Elemente zumindest teilweise drucktechnisch erzeugbar vorgesehen sind.

2. Druckprodukt nach Anspruch 1,
**gekennzeichnet dadurch, dass** die Bildebene als ein Druckmuster ausgebildet ist, das im Verfahren des Offsetdrucks, des Tiefdrucks oder des Flexodrucks oder in einer Kombination der genannten Druckverfahren hergestellt wird.

3. Druckprodukt nach Anspruch 1,
**gekennzeichnet dadurch, dass** die Ebene der elektrisch funktionalen Elemente ein oder mehrere Druckmuster aufweist, die zumindest teilweise in einem der Druckverfahren Offsetdruck, Tiefdruck oder Flexodruck oder in einer Kombination der genannten Druckverfahren aufgetragen wird.

4. Druckprodukt nach Anspruch 3,
**gekennzeichnet dadurch, dass** die Ebene der elektrisch funktionalen Elemente eine vollständige elektrische Funktionalität enthält, wobei diese in einem drucktechnischen Verfahren hergestellt wird.

5. Druckprodukt nach Anspruch 1 oder 3,
**gekennzeichnet dadurch, dass** die elektrisch funktionale Ebene wenigstens teilweise ein drucktechnisch erzeugte Schicht ist, wobei die elektrische Funktionalität wenigstens teilweise durch diskrete elektrische Bauelemente wie integrierte Schaltkreise (IC's) oder Leuchtdioden (LED's) erzeugt wird.

6. Druckprodukt nach Anspruch 1 bis 5,
**gekennzeichnet dadurch, dass** die elektrisch funktionale Ebene ein RFID-Transponder oder ein 1-bit Transponder für den Diebstahlschutz ist.

7. Druckprodukt nach Anspruch 1 bis 5,
**gekennzeichnet dadurch, dass** die elektrisch funktionale Ebene Leiterbahnen und / oder Tastaturelemente aufweist.

8. Druckprodukt nach Anspruch 1 bis 5,
**gekennzeichnet dadurch, dass** die elektrisch funktionale Ebene eine Stromversorgung, zum Beispiel eine Batterie, aufweist.

9. Druckprodukt nach Anspruch 1 bis 5,
**gekennzeichnet dadurch, dass** die elektrisch funktionale Ebene eine Anzeigevorrichtung, wie eine LED-Anzeige, aufweist.

10. Druckprodukt nach Anspruch 1 bis 5,
**gekennzeichnet dadurch, dass** die elektrisch funktionale Ebene einen oder mehrere Sensoren, wie zur Erfassung der Temperatur oder des Reifezustands eines verpackten Lebensmittels, aufweist.

11. Druckprodukt nach Anspruch 3 bis 10,
**gekennzeichnet dadurch, dass** die Ebene elektrischen Elemente eine gedruckte Schicht ist, die mittels leitfähiger, mit metallischen Pigmenten gefüllter Druckfarben und/oder leitfähiger Polymeren erzeugt wird.

12. Verfahren zur Herstellung eines Druckproduktes, bestehend aus einer transparenten Kunststofffolie, einer Bildebene, die aus einer gedruckten Bildinformation besteht, einer opaken oder teilopaken deckenden Ebene, die aus einem Deckweißauftrag aufgebaut wird, nach Anspruch 1 bis 11,
**gekennzeichnet dadurch,**
**dass** die Bildebene und der Deckweißauftrag über ein oder mehrere Druckwerke inline während eines Durchlaufs durch einen Druckprozess in einer Druckmaschine erfolgt, wobei gegebenenfalls zwischen den einzelnen Druckwerken der Druckmaschine eine Trocknung und/oder Härtung der Druck- und Deckweißschichten durch geeignete Trocknungs- bzw. Härtungsvorrichtungen erfolgt und anschließend inline, während des Druckprozesses, oder Offline in einer separaten Druck- oder Beschichtungsvorrichtung zumindest ein Teil der elektrisch funktionalen Schicht auf das Deckweiß aufgetragen wird.

13. Verfahren zur Herstellung eines Druckproduktes, bestehend aus einer transparenten Kunststofffolie, einer Bildebene, die aus einer gedruckten Bildinformation besteht, einer opaken oder teilopaken deckenden Ebene, die aus einem Deckweißauftrag aufgebaut wird, nach Anspruch 1 bis 11,
**gekennzeichnet dadurch,**
**dass** die Bildebene über ein oder mehrere Druckwerke inline während des Durchlaufens eines Druckprozesses in einer Druckmaschine erfolgt, wobei gegebenenfalls zwischen den einzelnen Druckwerken der Druckmaschine eine Trocknung und / oder Härtung der Druckschichten durch geeignete Trocknungs- bzw. Härtungsvorrichtungen erfolgt und anschließend offline, in einer separaten Druck- oder Beschichtungsvorrichtung die Deckweißschicht bzw. -schichten auf die Bildebene aufgetragen wird und anschließend in einer separaten Druck- oder Beschichtungsvorrichtung zumindest ein Teil der elektrisch funktionalen Schicht auf das Deckweiß aufgetragen wird.

14. Verfahren nach Anspruch 12 oder 13,
**gekennzeichnet dadurch, dass** der Druck der Bildinformationsebene und gegebenenfalls der Druck oder die Beschichtung der Deckweißebene in einer Bogenrotationsdruckmaschine.

15. Verfahren nach Anspruch 14,
**gekennzeichnet dadurch, dass** der Druck der Bildinformationsebene und gegebenenfalls der Druck oder die Beschichtung der Deckweißebene in einer Bogenoffsetmaschine mit Lackwerken erfolgt.
